Europäisches Patentamt

European Patent Office

Office européen des brevets

(11) Numero de publication

**0 013 520**
A1

## DEMANDE DE BREVET EUROPEEN

(21) Numéro de dépôt: **79401020.7**

(22) Date de dépôt: **14.12.79**

(51) Int. Cl.³: **H 01 L 21/285**
**H 01 L 29/48**

(30) Priorité: **28.12.78 FR 7836637**

(43) Date de publication de la demande:
**23.07.80 Bulletin 80/15**

(84) Etats Contractants Désignés:
**DE GB IT**

(71) Demandeur: **Société Anonyme LIGNES TELEGRAPHIQUES ET TELEPHONIQUES**
**1 Rue Charles Bourseul**
**F-78702 - Conflans-Ste Honorine(FR)**

(72) Inventeur: **Dameme, Guy Société Anonyme LIGNES TELEGRAPHIQUES**
**ET TELEPHONIQUES 1 Rue Charles Bourseul**
**F-78702 Conflans-Sainte-Honorine(FR)**

(72) Inventeur: **Watremez, Jean-Marie S.A. LIGNES TELEGRAPHIQUES**
**ET TELEPHONIQUES 1 Rue Charles Bourseul**
**F-78702 Conflans-Sainte-Honorine(FR)**

(74) Mandataire: **Guyot, Liliane et al,**
**Société Anonyme LIGNES TELEGRAPHIQUES ET TELPHONIQUES 1 Rue Charles Bourseul**
**F-78702 Conflans-Sainte-Honorine(FR)**

(54) **Procédé perfectionné de fabrication de diodes Schottky et diodes de puissance ainsi réalisées.**

(57) Procédé de fabrication de barrière siliciure de chrome-silicium pour diode Schottky permettant un ajustement de l'enfoncement (b) de la barrière sous la surface par contrôle de l'épaisseur (c) d'une couche de chrome (14) déposée sur un pavé de silicium (10) portant une couche épitaxiée (11).

Le chrome évaporé sous vide est entièrement combiné au silicium au cours d'un traitement thermique à une température comprise entre 600° C et 700°C.

Ce procédé permet de fabriquer des diodes de puissance de caractéristiques différentes par modification de l'épaisseur de la couche de chrome.

Fig 2b

EP 0 013 520 A1

Croydon Printing Company Ltd.

1

# PROCEDE PERFECTIONNE DE FABRICATION DE DIODES SCHOTTKY ET DIODES DE PUISSANCE AINSI REALISEES

La présente invention concerne un procédé de fabrication de diodes Schottky et plus particulièrement de diodes Schottky de puissance réalisées dans du silicium de type n dont la barrière de chrome est obtenue par évaporation sous vide. On trouve actuellement des diodes Schottky de puissance proposées par différents fabricants , par exemple la diode SD51 de chez T.R.W., atteignant un débit de 50 ampères spécifiée à une tension inverse maximale de 45 volts.

Les structures de diodes de puissance décrites dans l'art antérieur comportent le plus souvent une barrière de surface entourée par un anneau de garde constitué par du matériau semiconducteur de type p opposé au silicium de type n ou, à défaut, un anneau isolant (dit anneau d'oxyde de champ) destiné à ne pas limiter la tension inverse supportée par la structure. Une telle structure est notamment décrite dans le brevet français 1.559.346 déposé le 19 Mars 1968 pour : "Diode redresseuse à couche barrière et procédé pour la former". Dans les structures de l'art antérieur, avec ou sans anneau de garde, l'élément important, à savoir la barrière, est formé sur une surface dont la nature physico-chimique est difficile à contrôler par suite de la formation spontanée d'une mince couche d'oxyde à la surface du silicium et de la présence, également inévitable, de charges de surface et d'impuretés.

Le procédé de fabrication selon la présente invention a pour caractéristique essentielle un traitement thermique dans des conditions telles que la couche de chrome déposée par évaporation sous vide se combine entièrement avec le silicium pour

2

donner le composé intermétallique conducteur Cr $Si_2$, la profondeur de pénétration de la zone conductrice dans le silicium étant fixée en contrôlant l'épaisseur du dépôt de chrome ; la barrière Schottky est formée au contact entre le silicium et le composé intermétallique.

Selon une autre caractéristique de l'invention, la totalité des dépôts permettant la formation de la barrière et du contact ohmique et établissant les contacts d'anode et de cathode est effectuée dans la même enceinte à vide, suivant un cycle continu.

Un avantage du procédé selon l'invention réside en ce qu'il conduit à une structure dont la barrière est "enterrée", c'est-à-dire qu'elle se trouve formée dans la masse du silicium, à une profondeur suffisante pour s'affranchir des désordres de surface. Elle présente donc des caractéristiques plus stables et reproductibles. Les mesures en production ont montré que les diodes fabriquées selon l'invention ont des caractéristiques beaucoup plus groupées que celles réalisées selon l'art antérieur. Un autre avantage du procédé selon l'invention est qu'il permet de s'affranchir de l'anneau de garde, ce qui constitue une grande simplification du processus de fabrication.

Un avantage du procédé est qu'il permet de réaliser des diodes plus performantes que celles actuellement disponibles et en particulier des diodes de courant nominal 50 ampères supportant une tension inverse de 60 volts.

Un avantage du procédé est sa grande souplesse, il permet, en effet, partant d'une plaque de silicium n portant une couche épitaxiée de caractéristiques données (épaisseur et résistivité), de fabriquer une gamme importante de diodes de caractéristiques différentes en réglant l'enfoncement de la barrière en fonction des caractéristiques à obtenir.

La présente invention sera bien comprise en se reportant à la description suivante et aux figures qui l'accompagnent données à titre d'illustration non limitative et dans lesquelles :

- la figure 1 est un bloc diagramme du processus de fabrication ;
- la figure 2 est une vue en coupe d'une diode par un plan perpendiculaire à la jonction ;
- la figure 3 est une caractéristique d'une telle diode.

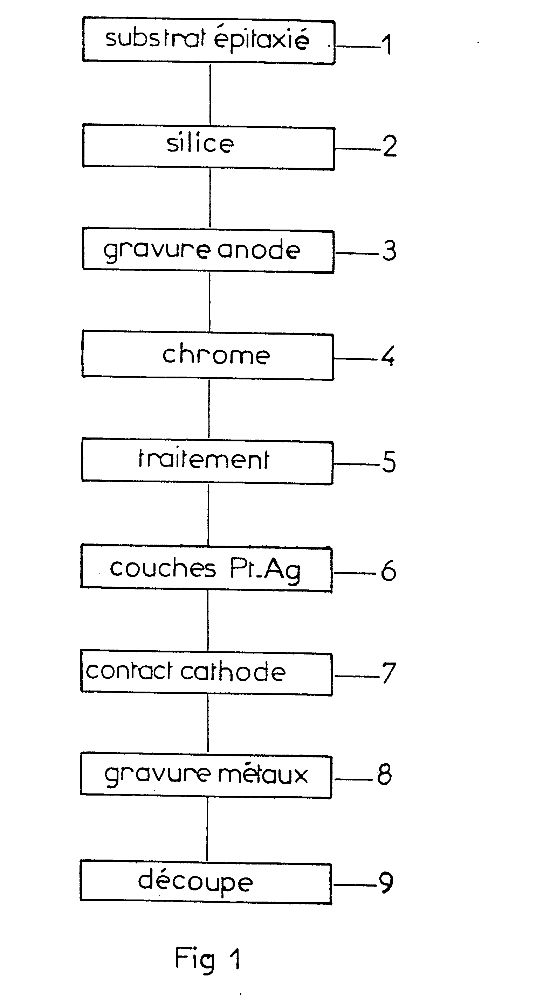

La figure 1 représente les différentes étapes de fabrication selon le procédé de l'invention. On a représenté en 1 la préparation des substrats de silicium. Les plaquettes de silicium de type n comportant environ $4.10^{18}$ impuretés au $cm^3$ (résistivité : quelques milliohms) sont recouvertes d'une couche épitaxiée comportant quelques $10^{15}$ impuretés au $cm^3$ (résistivité : 1,2 ohm-cm) d'une épaisseur de quelques microns. Ainsi qu'il a été dit plus haut, il est possible de conserver en stock une réserve de plaques épitaxiées identiques et de répondre au plan de fabrication en contrôlant deux stades opératoires, les autres restant identiques,pour obtenir plusieurs types de diodes différents. Les substrats sont ensuite traités par dépôt d'une couche de silice continue obtenue par oxydation thermique et gravure des fenêtres d'anodes, ainsi qu'il est connu de l'homme de l'art (opérations 2 et 3). La plaquette gravée est introduite dans une enceinte à vide d'où elle ne ressortira qu'après établissement des contacts d'anode et de cathode. Dans cette enceinte, la plaquette est soumise, après dégazage, à une mise en température à au moins 600°C, puis à l'évaporation d'une couche de chrome d'une épaisseur contrôlée en cours d'évaporation en fonction des paramètres de la couche épitaxiée et des caractéristiques de la diode à fabriquer. Pratiquement, l'intervalle compris entre 600° et 700°C s'est révélé le meilleur . L'évaporation du chrome se fait à une vitesse de quelques centièmes de μm par minute (stade opératoire 4). L'épaisseur de la couche est choisie égale à un tiers de l'enfoncement désiré de la barrière. L'épaisseur de chrome obtenue, l'évaporation est interrompue et la plaquette est maintenue en température pendant une durée qui n'est pas inférieure à cinq minutes (stade opératoire 5).La durée de ce traitement dépend de l'épaisseur de la couche de chrome évaporée. Ce traitement thermique est destiné à assurer la combinaison de la totalité du chrome avec le silicium de la couche épitaxiée, cette combinaison aboutissant à la formation du composé intermétallique conducteur de formule $Cr\,Si_2$. Le chrome qui recouvre la couche d'oxyde non éliminée au cours de la gravure est conservé pour faciliter l'adhérence des dépôts métalliques ultérieurs sur la surface de la plaquette. On procède ensuite à l'évaporation successive, dans la même enceinte, des couches conductrices destinées à constituer le contact des anodes. Ces couches sont, de préférence, une couche de platine servant de barrière de diffusion du métal de sortie et une couche ou une série de couches destinées à constituer le métal ou le sandwich de métaux de sortie, de l'argent de préférence (stade opératoire 6). La diode est terminée en ce qui concerne la partie anodique. La partie opposée de la plaquette de silicium est alors recouverte par les différentes couches destinées à constituer la sortie cathodique. De préférence, ces couches sont indentiques à celles constituant l'anode, c'est-à-dire qu'elles consistent en un dépôt de chrome suivi d'un dépôt de platine et d'un dépôt d'argent. Dans certains cas, on peut préférer remplacer cet ensemble de couches par une préforme d'alliage or-silicium plus ou moins dopée. La nature du contact constituant la cathode dépend essentiellement du type de boîtier destiné à abriter la diode. L'ensemble des dépôts du contact cathodique est représenté par l'étape 7. On a figuré en 8 l'étape de gravure des couches métalliques pour constituer les contacts de cathode (étape 8). Les diodes unitaires sont ensuite découpées dans la plaquette (étape 9) ainsi qu'il est bien connu.

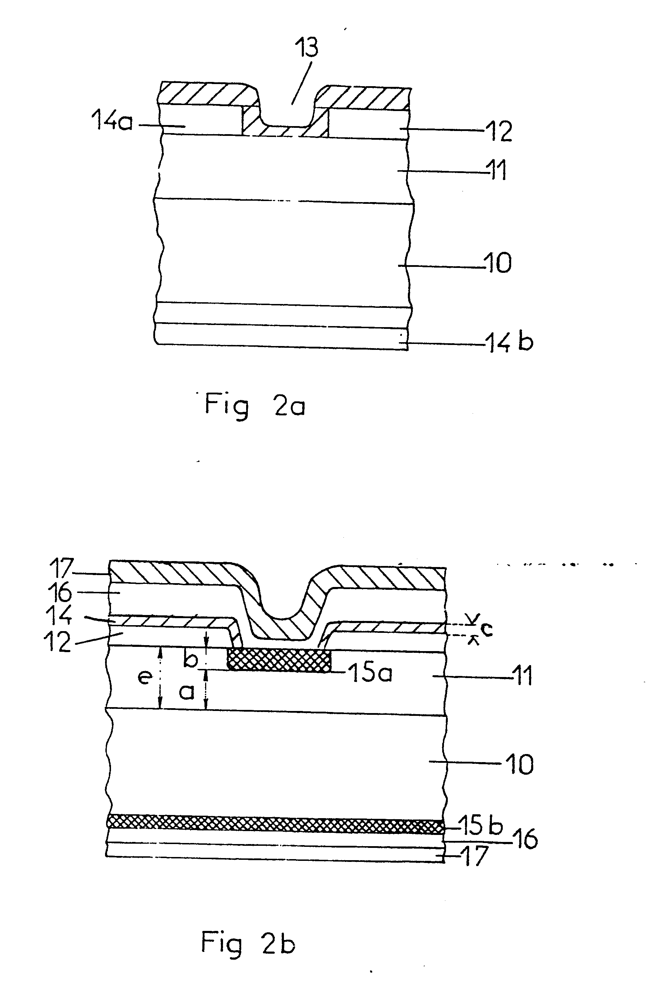

Les figures 2A et 2B représentent la diode vue en coupe à deux stades de la fabrication. On a représenté (figure 2A) en 10 le substrat de silicium de type $n^+$. Le taux de dopage du substrat 10 est tel que la résistivité soit de l'ordre de dix milliohms. Le substrat 10 est surmonté d'une couche épitaxiée 11 de silicium n obtenue par les procédés connus de l'homme de l'art dont la concentration en impureté est de l'ordre de $5.10^{15}$, soit une résis-tivité de 1,2 ohm-cm. L'ensemble 10 et 11 peut être stocké dans les conditions habituelles. En vue d'une fabrication, une couche de silice 12 est générée sur la face libre de la couche épitaxiée. La couche 12 est ensuite gravée ainsi qu'il est d'usage de façon à présenter des ouvertures 13 délimitant les anodes des diodes. La gravure des fenêtres d'anodes correspond à l'étape 3 du procédé. La couche de chrome (étape 4) 14 est déposée sur la totalité de la surface du silicium et de l'oxyde non éliminé 12. Au cours du traitement thermique, le chrome qui se trouve au contact du silicium (couche 11) dans la fenêtre d'anode réagit avec celui-ci de façon à former le composé intermétallique Cr $Si_2$. Ce composé se faisant à partir de deux atomes de Si pour un de chrome, le contact entre le composé et le silicium se trouve à l'intérieur de l'épaisseur de la couche 11, ainsi qu'il est représenté en pointillé en 15a (figure 2B). Le chrome qui se trouvait déposé dans la fenêtre d'anode a disparu pour se combiner avec le silicium . La formation du composé 15a correspond à l'étape 5 du processus de fabrication. La couche de platine 16 est la barrière de diffusion entre le Cr et le métal de sortie. Le métal de sortie est constitué par la couche 17 le plus souvent en argent. Le contact cathodique sur la face inférieure de la plaquette 10 est constitué des mêmes métaux : on retrouve en 15b la couche de Cr $Si_2$, en 16 la barrière de diffusion en platine et en 17 le métal de sortie (argent).

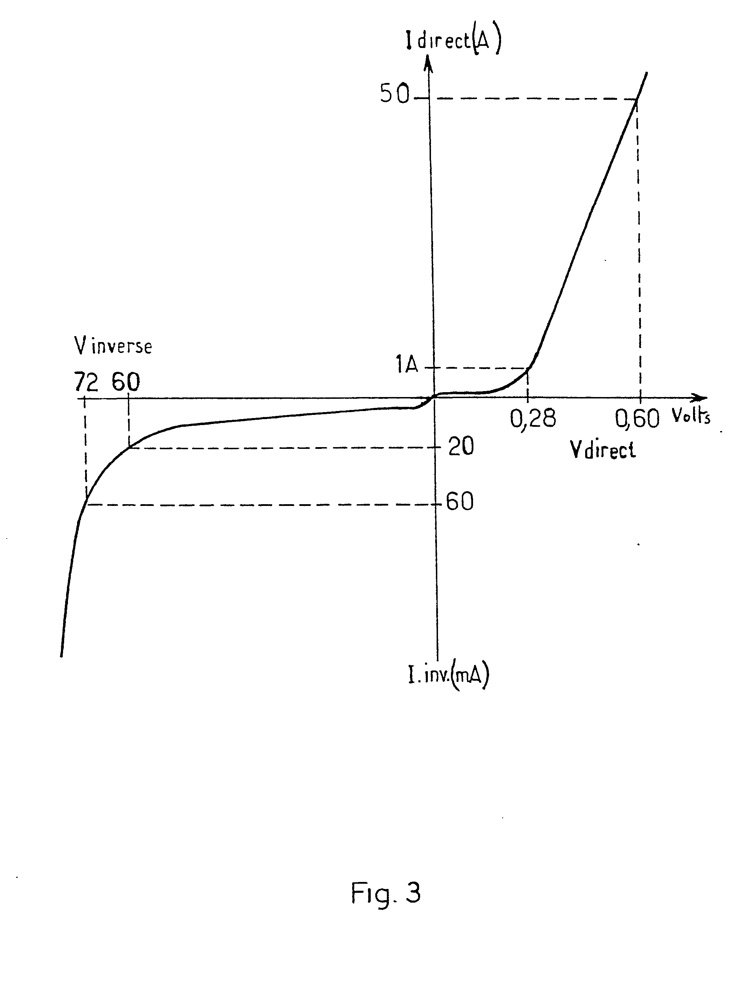

La figure 3 représente une caractéristique moyenne de diodes Schottky fabriquées selon le procédé de l'invention, de courant nominal 50 ampères et de tension inverse 60 volts. La chute de tension directe moyenne de ces diodes est de 0,60 volt au courant maximal.

S'agissant de fabriquer des diodes ayant une certaine tension inverse et un certain courant nominal, on choisit parmi les quelques substrats épitaxiés normalisés en stock, par exemple une plaquette ayant une couche épitaxiée d'une épaisseur de 5,5 microns et une résistivité de 1,2 ohm-cm.La tension inverse à supporter définit la valeur (voir figure 2b) de la distance minimale a entre la barrière 15a et le substrat 10. La résistance série de la diode est, bien entendu, fonction de cette épaisseur entre autre. Il est donc souhaitable de choisir pour a la valeur minimale afin de réduire la résistance série, c'est-à-dire la chute de tension directe de la diode. La valeur choisie du paramètre a, compte tenu de l'épaisseur e de la couche épitaxiée, définit la profondeur
de pénétration b de la barrière. Celle-ci est liée
à l'épaisseur de la  couche de chrome c par la relation b = 3c. On a donc défini la quantité de chrome
à évaporer au cours de l'opération 4. La durée du
traitement thermique (opération 5) est choisie de
façon à assurer la combinaison de la totalité du
chrome de la couche 14 avec le silicium de la couche
11. L'étude de la cinétique de la réaction du chrome
sur le silicium, à la température de chauffage de la
plaquette, permet de définir la durée de l'opération.
Pour maintenir le coût minimum, il est souhaitable
de choisir la durée minimale compatible avec la garantie d'une combinaison totale du chrome. Compte tenu
des valeurs des paramètres e et b correspondant à des
diodes de forte puissance, on peut dire qu'une durée
minimale de cinq minutes du traitement thermique convient dans la plupart des cas pratiques. Les valeurs
pratiques des paramètres a et b pour les diodes de
puissance réalisées à partir d'une couche 11 de résistivité 1,2 ohm-cm et d'épaisseur 5,5μm sont les
suivantes :

|  | : courant : maximum | : tension inverse maximum | : a en μm | : b en μm |
|---|---|---|---|---|
|  | : | : | : | : |
|  | : | : | : | : |
| diode | : 50 A | : 60 V | : 4,5 | : 1 |
|  | : 50 A | : 40 V | : 3,5 | : 2 |
|  | : 50 A | : 20 V | : 2,5 | : 3 |

La courbe de la figure 3 est une caractéristique
tension-courant de diode Schottky réalisée selon l'invention et spécifiée pour un débit maximum de 50 ampères
et une tension inverse maximum de 60 volts. On remarquera que les graduations de la partie positive de l'axe des ordonnées est en ampère et la partie négative en milliampère ; dans le cas des abscisses, les tensions sont indiquées en volt, mäis les échelles diffèrent également. Le coude de la caractéristique directe se situe à 0,28 volt/1 ampère et celui de la caractéristique inverse à -60 volts/-20 milliampères.

L'exemple qui vient d'être donné à titre d'illustion constitue la variante préférée de mise en oeuvre du procédé. Toutefois, celui-ci est utilisable à la fabrication de diodes Schottky de tout modèle et confère au produit fabriqué l'avantage d'une grande stabilité résultant de l'affranchissement des éléments instables (charges - impuretés) qui existent à la surface de la couche épitaxiée.

0013520

REVENDICATIONS

1 - Procédé de fabrication de diodes Schottky de puissance à barrière Cr $Si_2$/Si comportant les opérations suivantes :
- préparation d'une plaquette en silicium $n^+$
- dépôt d'une couche épitaxiée en silicium n d'épaisseur e = a + b où b est la profondeur de la barrière et a l'épaisseur de la couche épitaxiée conservée dans la diode finie
- dépôt d'une couche de silice et masquage
- gravure des fenêtres d'anode
- dépôt sous vide d'une épaisseur contrôlée de Cr à une température supérieure à 600°C d'épaisseur c = b/3
- traitement thermique pendant au moins cinq minutes à une température T telle que 600°C<T<700°C
- dépôt des couches conductrices destinées au contact d'anode
- dépôt des couches conductrices destinées au contact de cathode
- gravure des couches de contact de cathode
- séparation des diodes unitaires.

2 - Diode Schottky de puissance constituée d'une plaquette de silicium comportant une barrière Si-$Si_2$ Cr située à au moins 1μm sous la surface externe de la plaquette dans une couche épitaxiée de résistivité 1,2 ohm-cm.

3 - Diode Schottky de puissance selon revendication 2, dans laquelle la couche épitaxiée a une épaisseur e de 5,5μm et une résistivité de 1,2 ohm-cm.

4 - Diode Schottky de puissance selon revendication 1,dans laquelle les couches conductrices destinées au contact de cathode sont identiques à celles utilisées à la formation de l'anode.

11.

5 - Diode Schottky de puissance selon revendication 4, dans laquelle lesdites couches conductrices sont, outre le chrome, le platine et l'argent.

0013520

1/3

| substrat épitaxié | —1 |
| silice | —2 |
| gravure anode | —3 |
| chrome | —4 |
| traitement | —5 |
| couches Pt.Ag | —6 |
| contact cathode | —7 |
| gravure métaux | —8 |
| découpe | —9 |

Fig 1

0013520

13

14a — — 12

11

10

14 b

Fig 2a

17
16
14
12
15a — 11
b
e a
10
15 b — 16
17

Fig 2b

Fig. 3

0013520

Numéro de la demande

Office européen
des brevets

**RAPPORT DE RECHERCHE EUROPEENNE**

F: 79 40 1010

| Categorie | Citation du document avec indication en cas de besoin des parties pertinentes | Revendication concernee | CLASSEMENT DE LA DEMANDE (Int Cl |
|---|---|---|---|
| | **DOCUMENTS CONSIDERES COMME PERTINENTS** | | |
| | FR - A - 2 014 851 (WESTERN ELEC-TRIC)<br>* Figures 1-3; revendication 1-3; page 2, lignes 7-14, 20-28; page 3, ligne 38; page 4, ligne 6 * | 1,2,5 | H C1 L 21/285<br>29/48 |
| | FR - A - 1 430 595 (WESTERN ELECTRIC)<br>* Figures 1,4; resumé A 1,2, B 1,2; page 2, colonne de droite, 2e alinea * | 1,2,5 | |
| | FR - A - 2 360 993 (LIGNES TELEGR ET TELEPH.)<br>* Revendications 1-3; page 2, lignes 5-13; page 3, lignes 19-22 * | 1-4 | **DOMAINES TECHNIQUES RECHERCHES (Int. Cl**<br>H 01 L 21/285<br>29/48<br>29/40<br>29/91 |
| | JOURNAL OF APPLIED PHYSICS, vol. 47, décembre 1976, New York US J.O. OLOWOLAFE et al. "Formation kinetics of $CrSi_2$ films on Si substrates with and without interposed $Pd_2Si$ layer" pages 5182-5186.<br>* Page 5183, colonne de gauche, 1er alinea * | 1,2 | **CATEGORIE DES DOCUMENTS CITES**<br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cite pour d'autres raisons |
| | JAPANESE JOURNAL OF APPLIED PHYSICS vol. 10, fevrier 1971, Tokyo, JP P.A. MHASKAR et al. "On the effect of heat treatment on Cr-Si | 1-3<br>./. | &: membre de la même famille, document correspondant |

Le présent rapport de recherche a été etabli pour toutes les revendications

| Lieu de la recherche | Date d'achevement de la recherche | Examinateur |
|---|---|---|
| La Haye | 08-04-1980 | DE RAEVE |

OEB Form 1503.1 06.78

**Office européen des brevets**

**RAPPORT DE RECHERCHE EUROPEENNE** : 79 ⋅ ⵍ ⵍ ⵍ

| CATÉGORIE | DOCUMENTS CONSIDERES COMME PERTINENTS | Revendica-tion concernée | CLASSEMENT DE LA DEMANDE (Int. Cl. 3) |
|---|---|---|---|
| | Citation du document avec indication, en cas de besoin, des parties pertinentes | | |
| | Schottky barriers", pages 277-278.<br><br>* Page 277, colonne de gauche; 2e alinéa *<br><br>-- | | |
| | APPLIED APHYSICS LETTERS, vol. 20, mai 1972,<br>New York US<br>R.W. BOWER et al. "Growth kinetics observed in the formation of metal silicides on silicon", pages 359-361.<br><br>* Page 360, colonne de gauche, 1er alinéa; figure 1(b) *<br><br>---- | 1,2 | **DOMAINES TECHNIQUES RECHERCHES (Int. Cl. 3)** |